# EUROPÄISCHE PATENTSCHRIFT

(11) **EP 0 277 613 B1**
(45) Veröffentlichungstag und Bekanntmachung des Hinweises auf die Patenterteilung: **30.11.1994**
(21) Anmeldenummer: 88101359.3
(22) Anmeldetag: 30.01.1988
(51) Int. Cl.: H03M 7/30, H04B 1/66

(54) **Verfahren zur Übertragung eines Audiosignals**
Audio signal transmission method
Procédé de transmission de signal audio

(30) Priorität: 03.02.1987 DE 3703143
(43) Veröffentlichungstag der Anmeldung: 10.08.1988
(73) Patentinhaber: Deutsche Thomson-Brandt GmbH, 78003 Villingen-Schwenningen (DE)
(72) Erfinder: Schröder, Ernst, Dipl.-Ing., D-3000 Hannover 91 (DE); Voessing, Walter, Dipl.-Ing., D-3015 Wennigsen 1 (DE)

(56) Entgegenhaltungen:
- EP-A- 0 193 143
- EP-A- 0 251 028
- RUNDFUNKTECHISCHE MITTEILUNGEN, Band 30, Nr. 3, Mai/Juni 1986, Seiten 117-123;D. KRAHE: "Ein Verfahren zur Datenreduktion bei digitalen Audiosignalen unter Ausnutzung psychoakustischer Phänomene"

## Beschreibung

Die Erfindung betrifft ein Verfahren zur Übertragung eines Audiosignals, bei dem unterhalb vorgegebener Schwellen liegende Anteile dieses Signals bei der Codierung nicht berücksichtigt werden.

Ein derartiges Verfahren ist bereits aus der EP-A-0 193 143 bekannt. Mit Hilfe dieses Verfahrens ist es möglich, die für die Übertragung notwendige Bandbreite klein zu halten, um mit einem schmalbandigen Kanal auszukommen, auf einem vorhandenen Kanal möglichst viele Audiosignale gleichzeitig übertragen zu können oder einen vorhandenen Massenspeicher möglichst wirtschaftlich ausnutzen zu können. Dabei wird die Erkenntnis ausgenutzt, daß aufgrund psycho-akustischer Eigenschaften des Gehörs nicht alle Komponenten einer Schalldarbietung vom Hörer wahrgenommen werden, also im nachrichtentechnischen Sinn irrelevant sind. Diese Komponenten, die einen beträchtlichen Teil der sonst erforderlichen Übertragungskapazität beanspruchen würden, werden weggelassen. sen.

In EP-A-0 251 028 (veröffentlicht am 07.01.88) und in D. Krahé, Rundfunktech. Mitteilungen, 30(1986), Heft 3, S. 117-123, werden im Kurzzeit-Spektrum eines Audiosignals unterhalb vorgegebener Schwellen liegende Anteile dieses Signals bei der Codierung nicht berücksichtigt.

Es hat sich gezeigt, daß zur Entscheidung der Frage, welche Komponenten weggelassen werden können, verschiedene Kriterien für sich oder in Kombination mit anderen Kriterien berücksichtigt werden müssen. Unterbleibt diese Berücksichtigung, kann das Weglassen bestimmter Komponenten bei bestimmten ungewöhnlichen Schallereignissen zu unbefriedigenden Hörergebnissen führen.

Der Erfindung liegt deshalb die Aufgabe zugrunde, ein Verfahren zur Übertragung eines Audiosignals anzugeben, bei dem eine Datenreduktion so vorgenommen wird, daß auch bei außergewöhnlichen Schallereignissen keine Verschlechterung des Höreindrucks eintritt.

Diese Aufgabe wird bei einem Verfahren nach dem Oberbegriff des Anspruchs 1 durch die im kennzeichnenden Teil angegebenen Merkmale gelöst.

Bei der Umwandlung des Signals in ein das Kurzzeitspektrum darstellende Signal, was durch blockweise Transformation erfolgt, können Spektralkomponenten entstehen, die im Langzeitspektrum nicht vorhanden sind. Die Berücksichtigung dieser Sektralkomponenten bei der Rückstransformation ist wichtig, um wieder ein getreues Abbild des ursprünglichen Signals zu erhalten. Würden die Spektralkomponenten im Zuge der Datenreduktion unterdrückt, so würde dies zu einer wahrnehmbaren Verfälschung der Tondarbietung führen.

Eine der Maßnahmen zur Datenreduktion besteht aber gerade darin, Spektralkomponenten mit einem Betragswert unterhalb einer vorgegeben Schwelle zu unterdrücken oder nicht zu berücksichtigen. Die grundsätzliche Zulässigkeit dieser Maßnahme angesichts der widersprechenden Forderungen nach hoher Wiedergabequalität beruht auf dem psycho-akustischen Verdeckungseffekt.

Es hat sich nun aber gezeigt, daß dieser Verdeckungseffekt dann nicht immer ausgenutzt werden kann, wenn von der Unterdrückung Spektralkomponenten betroffen sind, die ursächlich durch die blockweise Transformation zusätzlich im Kurzeitspektrum entstanden sind. Dies gilt selbst dann, wenn die Spektralkomponenten unterhalb derjenigen Schwelle liegen, bei der die Unterdrückung anderer Spektralkomponenten zu keiner hörbaren Qualitätseinbuße führen würde.

Es wäre wünschenswert, wenn die durch blockweise Transformation entstandenen zusätzlichen Spektralkomponenten von den anderen unterschieden werden könnten, so daß eine identifizierbare Einteilung in "wesentliche" und "unwesentliche" Spektralkomponenten möglich wäre. Dies ist jedoch nicht der Fall.

Daher muß eine Unterdrückung der Spektralkomponenten in solchen Frequenzbereichen eingeschränkt werden, in denen ein Verdeckungseffekt nicht sicher gewährleistet ist. Um die Datenreduktion durch Unterdrückung von Spektralkomponenten geringer Betragswerte aber trotzdem beibehalten zu können, wird diese Maßnahme unterhalb einer ersten definierten Schwelle nur in außerhalb psycho-akustisch differenzierbarer Frequenzbereiche liegenden Frequenzbereichen durchgeführt.

Eine Weiterbildung der Erfindung sieht konkrete Frequenzbereiche vor, in denen der Verdeckungseffekt nicht sicher wirksam wird und daher eine Unterdrückung von Spektralkomponenten nachteilig sein kann. Es handelt sich hierbei zum einen um den niedrigen Frequenzbereich unterhalb etwa 1 kHz und zum anderen um die unmittelbare Umgebung der größten Spektralkomponente des Tonsignals. Die Angabe des letzteren Frequenzbereichs beruht auf der Erkenntnis, daß hier die "wesentlichen" Spektralkomponenten mit besonders hoher Wahrscheinlichkeit auftreten und deren Unterdrückung auch dann noch von qualitätsminderndem Einfluß ist, wenn ihre Betragswerte weit unterhalb der vorgegebenen Schwelle liegen.

Zusätzliche Weiterbildungen und vorteilhafte Ausführungsformen der Erfindung ergeben sich aus den Ansprüchen, der Beschreibung sowie der Zeichnung, die ein Ausführungsbeispiel veranschaulicht.

In der Zeichnung zeigen:
- Fig. 1: einen Block eines in den Frequenzbereich transformierten Audiosignals in Betragsdarstellung,
- Fig. 2: ein Flußdiagramm zur Veranschaulichung des

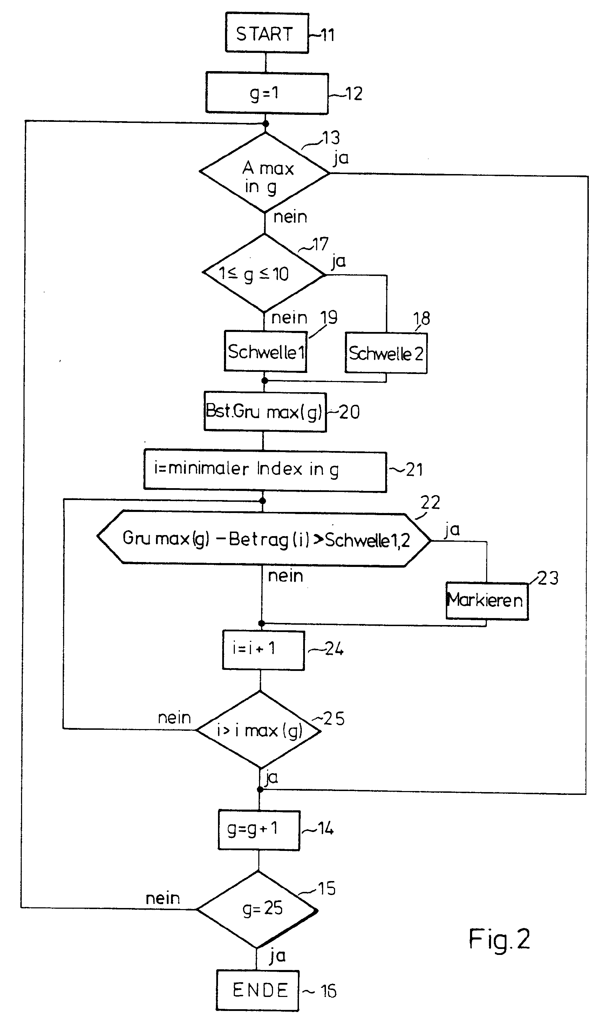

- Fig. 2: ein Flußdiagramm zur Veranschaulichung des erfindungsgemäßen Verfahrens.

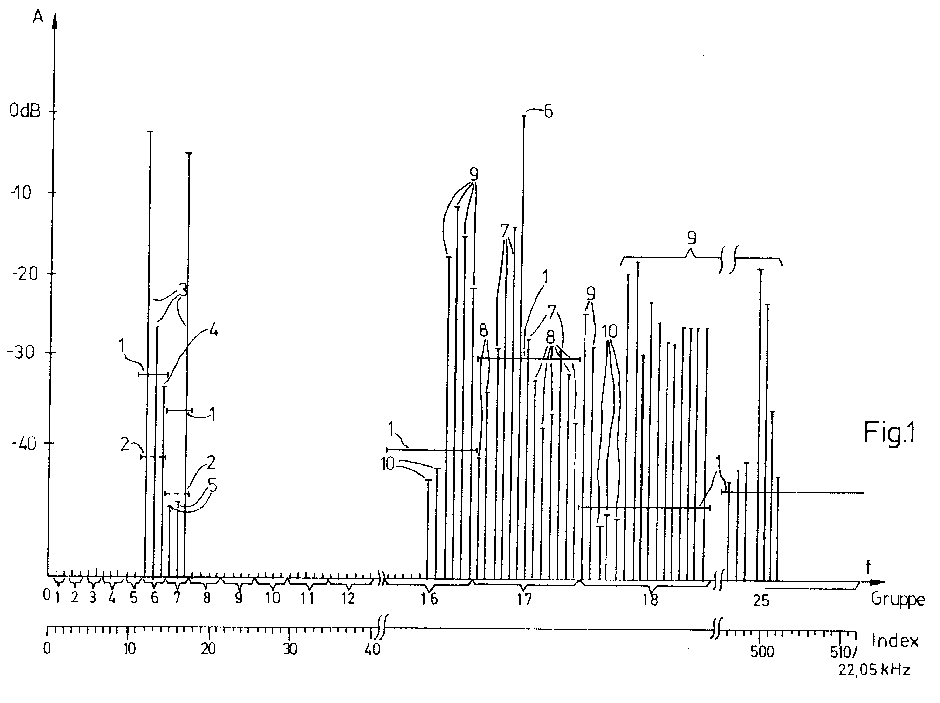

Das in Fig. 1 dargestellte Signal ergibt sich, indem ein tiefpaßgefiltertes Audiosignal durch einen Analog/Digital-Wandler in ein Digitalsignal umgewandelt, durch ein Zeitfenster ein bestimmter Abschnitt des digitalen Audiosignals aus dem Langzeitsignal ausgeschnitten wird und der so erhaltene Block vom Zeitbereich in den Frequenzbereich transformiert wird.

Im Ausführungsbeispiel ist die Frequenzachse in 513 Orte mit den Indizes 0 ... 512 unterteilt, denen Spektralkomponenten zugeordnet werden können. Mehrere dieser Orte sind zu Frequenzgruppen zusammengefaßt, von denen es insgesamt 26 gibt. Die Anzahl der Orte für Spektralkomponenten in den einzelnen Frequenzgruppen g ist unterschiedlich und steigt von niedrigen Frequenzgruppen zu höheren Frequenzgruppen hin an.

Wegen der Vielzahl der Orte wurde auf eine maßstäbliche Darstellung über der Frequenzachse verzichtet. Es sind nur die Bereiche gedehnt gezeichnet, welche für die Erläuterung der erfindungsgemäßen Lösung bedeutend sind. Es handelt sich hierbei um den Frequenzbereich unterhalb von etwas über 1 kHz, den hier die Gruppen 0 bis 12 repräsentieren, sowie den übrigen Frequenzbereich, aus dem beispielshalber die Gruppen 16, 17 und 18 ausgewählt worden sind.

In der Ordinate sind die Beträge der Spektralkomponenten logarithmiert und auf den Wert des absoluten Maximums bezogen. Das in der Zeichnung dargestellte Spektrum ist ein Kurzzeitspektrum, dessen Spektrallinien einmal durch das Originalsignal hervorgerufen, zum anderen aber auch durch die blockweise Transformation, also durch Faltung der Signalfunktion mit der Transformierten der Zeitfensterfunktion entstanden sind.

Auch die bei der blockweisen Transformation zusätzlich entstandenen Spektrallinien sind von Bedeutung, um nach der Übertragung und Rücktransformation des Signals vom Frequenzbereich in den Zeitbereich wieder ein getreues Abbild des ursprünglichen Signals zu erhalten.

Um bei der Übertragung oder Speicherung Übertragungs- bzw. Speicherkapazität einzusparen, wurde bisher so vorgegangen, daß Spektralanteile unterhalb einer Schwelle 1, welche in jeder Gruppe g gesondert auf den maximalen Betragswert der Spektralkomponenten dieser Gruppe g bezogen ist und durch das logarithmierte Verhältnis von Effektivwert des maximalen Betragswertes zur Wurzel aus der mittleren Energie aller Spektralkomponenten dieser Gruppe, multipliziert mit einem Faktor 3 definiert ist, nicht berücksichtigt oder unterdrückt, z.B. auf einen sehr kleinen Betragswert oder zu Null gesetzt wurden. Dies kann jedoch dann zu unbefriedigenden Ergebnissen führen, wenn die nicht berücksichtigten Spektralkomponenten durch die blockweise Transformation zusätzlich enstanden sind. Da diese aber nicht von den anderen Spektralkomponenten unterschieden werden können, wird abweichend von der generellen nicht Berücksichtigung oder Unterdrückung von Spektralkomponenten, die unterhalb der Schwelle 1 liegen, das Verfahren in folgender Weise modifiziert.

Im Bereich unter etwa 1 kHz, das sind hier die Gruppen 1 bis 10 wird eine zusätzliche Schwelle 2 definiert, welche unterhalb der Schwelle 1, vorzugsweise 10 dB darunter angeordnet ist. Liegen Spektralkomponenten, z.B. die mit 3 bezeichneten Spektralkomponenten oberhalb der Schwelle 1, so werden sie codiert und übertragen. Liegen sie unterhalb der Schwelle 1 aber noch oberhalb der Schwelle 2, wie es bei der Spektralkomponente 4 der Fall ist, werden sie ebenfalls übertragen. Erst bei den mit 5 bezeichneten Spektralkomponenten, die auch unterhalb der Schwelle 2 liegen, erfolgt eine Unterdrückung.

Eine weitere Modifizierung erfolgt in der näheren Umgebung des absoluten Maximums der Betragswerte des Spektrums. Bei dem als Beispiel dienenden Spektrum befindet sich die Spektralkomponente mit dem höchsten Betragswert 6 in der Gruppe 17. Unabhängig davon, ob die benachbarten Spektralkomponenten 7 und 8 oberhalb der Schwelle 1, wie bei den Spektralkomponenten 7 der Fall, oder unterhalb der Schwelle 1, wie bei den Spektralkomponenten 8 der Fall, liegen, findet eine Unterdrückung nicht statt. Dies gilt unabhängig davon, in welcher Gruppe g die Spektralkomponente 6 mit dem absoluten Maximum des Amplitudenwerts liegt. Auch wenn dies im Frequenzbereich der Gruppen 0 bis 10 der Fall ist, findet keine Unterdrückung der Spektralkomponenten statt.

In den sich anschließenden unteren bzw. oberen Gruppen 16 und 18 dagegen werden die oberhalb der Schwelle 1 liegenden Spektralkomponenten, hier mit 9 bezeichnet, übertragen und die unterhalb gelegenen Spektralkomponenten 10 unterdrückt.

Die Durchführung des Verfahrens wird zweckmäßig mit demselben Rechner durchgeführt, mit dem auch die Transformation und Codierung erfolgt. Zur Erläuterung des Verfahrensablaufs wird auf Fig. 2 Bezug genommen, welches ein Flußdiagramm darstellt. Nach dem Start in 11 wird in 12 die Gruppe mit der Gruppennummer g = 1 angesteuert. Die Gruppe g = 0 nimmt eine Sonderstellung ein, da sie einen Gleichanteil darstellt und für den Verfahrensablauf nicht weiter von Bedeutung ist. In 13 wird dann eine Entscheidung getroffen, ob die untersuchte Gruppe 9 das absolute Maximum des Betragswertes enthält.

Ist das der Fall, wird keine Unterdrückung der in dieser Gruppe befindlichen Spektralkomponenten durchgeführt, sondern nach 14 verzweigt, die zu untersuchende Gruppennummer in die nächstfolgende Nummer geändert und bei 15 eine Entscheidung herbeigeführt, ob alle Gruppen untersucht sind. Ist dies der Fall, so ist die Untersuchung für den betreffenden Block abgeschlossen und die Routine 16 beendet. Es erfolgt dann bei der Gewinnung des nächsten Blocks ein Rücksprung zum Start 11 und die Routine beginnt erneut.

Ist dies noch nicht der Fall, so wird nach 13 zurückgesprungen und geprüft, ob die jetzt untersuchte Gruppe g das absolute Maximum enthält. Enthält die Gruppe g das absolute Maximum, wird in 17 geprüft, ob die untersuchte Gruppe im Bereich der Ordnungszahlen 1 bis 10 liegt. Ist dies der Fall, so ist in 18 die Schwelle 2 für die nicht Berücksichtigung oder Unterdrückung der Spektralkomponenten maßgebend, welche um 10 dB tiefer liegt als die Schwelle 1. Liegt die Gruppe außerhalb des Bereichs der Gruppen 1 bis 10 ist die Schwelle 1 in 19 maßgebend.

In 20 wird nun bei der Gerade untersuchten Gruppe g das Gruppenmaximum, d.h. die Spektralkomponente des maximalen Betragswerts in derselben Gruppe bestimmt. Anschließend findet eine Prüfung der weiteren Spektralkomponenten dieser Gruppe statt. Dazu wird in 21 zunächst die Spektralkomponente mit dem kleinsten Index innerhalb der gerade untersuchten Gruppe g untersucht. In 22 wird geprüft, ob die Spektralkomponente unterhalb der Schwelle 1 oder 2 liegt. Diese Prüfung erfolgt unter Berücksichtigung des Gruppenmaximums. Zu diesem Zweck wird die Differenz aus dem Gruppenmaximum und aus dem Betrag der jeweiligen Spektralkomponente gebildet. Ist die Differenz größer als die Schwelle, d.h. liegt die Spektralkomponente unterhalb der Schwelle 1 oder 2, wird die Spektralkomponente in 24 zum Unterdrücken markiert. Im anderen Fall erfolgt keine Markierung.

In 25 wird der Index der gerade untersuchten Spektralkomponente um 1 weitergezählt und in 26 geprüft, ob der Index i größer als der maximale Index der Gruppe ist. Ist das nicht der Fall, wird die nächste Gruppe 9 angesteuert. Ist das der Fall, wird die Spektralkomponente mit dem nächsten Index in gleicher Weise geprüft.

Nach Prüfung der Spektralkomponente mit dem Index 512 in der Gruppe der Nr. 25 ist, wie bereits erwähnt, die Prüfung beendet und es erfolgt bei der nun folgenden Codierung der transformierten Signalblöcke eine entsprechende Unterdrückung der markierten Spektralkomponenten. Bei Vorliegen des nächsten transformierten Signalblocks läuft das Verfahren dann wieder von vorne mit dem Start 11 ab.

## Patentansprüche

1. Verfahren zur Übertragung eines Audiosignals, bei dem das analoge Signal in ein digitales Signal umgewandelt, digital übertragen und wieder in ein analoges Signal umgesetzt wird, wobei vor der Übertragung das Signal in ein das Kurzzeitspektrum darstellendes Signal umgewandelt wird und Anteile dieses Signals auf Basis psycho-akustischer Gesetzmäßigkeiten bei der Codierung des zu übertragenden digitalen Signals unterhalb vorgegebener Schwellen nicht berücksichtigt werden, wobei der gesamte Frequenzbereich des Kurzzeitspektrums in Frequenzgruppen (g) aufgeteilt ist, die jeweils wenigstens eine Spektralkomponente enthalten und in jeder Gruppe (g) wenigstens eine erste Schwelle (1) definiert ist, die insbesondere auf den maximalen Betragswert der Spektralkomponenten der betreffenden Gruppe (g) bezogen ist,
dadurch gekennzeichnet, daß für die außerhalb psycho-akustisch differenzierbarer Frequenzbereiche liegenden Frequenzgruppen die Betragswerte des Kurzzeitspektrums die unterhalb dieser ersten Schwelle (1) liegen nicht berücksichtigt werden, und daß für die innerhalb eines ausgewählten Teilbereichs des psycho-akustisch differenzierbaren Frequenzbereiches liegenden Frequenzgruppen eine zweite, unterhalb der ersten Schwelle (1) liegende Schwelle (2) definiert ist, unterhalb der die Betragswerte des Kurzzeitspektrums ebenfalls nicht berücksichtigt werden.

2. Verfahren nach Anspruch 1, dadurch gekennzeichnet, daß ein psycho-akustisch differenzierbarer Frequenzbereich durch den Frequenzbereich vorzugsweise unterhalb von 1 kHz und/oder durch die Umgebung des absoluten Maximums (6) der Betragswerte des Kurzzeitspektrums gebildet sind.

3. Verfahren nach Anspruch 1, dadurch gekennzeichnet, daß der ausgewählte Teilbereich innerhalb des psycho-akustisch differenzierbaren Frequenzbereichs durch den Frequenzbereich unterhalb von 1 kHz gebildet ist.

4. Verfahren nach einem der Ansprüche 1 bis 3, dadurch gekennzeichnet, daß die zweite Schwelle (2) um vorzugsweise 10 dB unterhalb der ersten Schwelle (1) liegt.

5. Verfahren nach Anspruch 1, dadurch gekennzeichnet, daß die erste Schwelle (1) durch das logarithmierte Verhältnis von Effektivwert des maximalen Betragswertes der Spektralkomponenten jeder Gruppe (g) zur Wurzel aus der mittleren Energie aller Spektralkomponenten dieser Gruppe (g), multipliziert mit einem konstanten Faktor von vorzugsweise 3 definiert ist.

6. Verfahren nach Anspruch 5, dadurch gekennzeichnet, daß die erste Schwelle (1) auf einen Variationsbereich des logarithmierten Verhältnisses zwischen 30 dB und 70 dB begrenzt ist.

7. Verfahren nach Anspruch 3, dadurch gekennzeichnet, daß der durch die Umgebung des absoluten Maximums (6) der Betragswerte des Kurzzeitspektrums gebildete Frequenzbereich mit dem Frequenzbereich übereinstimmt, den die das absolute Maximum der Betragswerte enthaltende Gruppe (g) einnimmt.

## Claims

1. A method of transmitting an audio signal wherein the analogue signal is converted into a digital signal, is transmitted in digital form and is reconverted into an analogue signal, where prior to the transmission the signal is converted into a signal representing the short-term spectrum and on the basis of psycho-acoustic laws components of this signal are not taken into consideration in the coding of the digital signal to be transmitted below predetermined thresholds, where the entire frequency range of the short-term spectrum is divided into frequency groups (g) which in each case contain at least one spectral component and in each group (g) at least one first threshold (1) is defined which relates in particular to the maximum amount value of the spectral components of the respective group (g), characterised in that for the frequency groups lying outside of psycho-acoustically differentiable frequency ranges the amount values of the short-term spectrum which lie below this first threshold (1) are not taken into consideration and that for the frequency groups lying inside a selected sub-range of the psycho-acoustically differentiable frequency range a second threshold (2) is defined which lies below the first threshold (1) and below which the amount values of the short-term spectrum likewise are not taken into consideration.

2. A method as claimed in Claim 1, characterised in that a psycho-acoustically differentiable frequency range is formed by the frequency range preferably below 1 kHz and/or by the neighbourhood of the absolute maximum (6) of the amount values of the short-term spectrum.

3. A method as claimed in Claim 1, characterised in that the selected sub-range within the psycho-acoustically differentiable frequency range is formed by the frequency range below 1 kHz.

4. A method as claimed in one of Claims 1 to 3, characterised in that the second threshold (2) lies preferably 10 dB below the first threshold (1).

5. A method as claimed in Claim 1, characterised in that the first threshold (1) is defined by the logarithmized ratio of the effective value of the maximum amount value of the spectrum components of each group (g) to the root of the mean energy of all the spectral components of this group (g), multiplied by a constant factor of preferably 3.

6. A method as claimed in Claim 5, characterised in that the first threshold (1) is limited to a variation range of the logarithmized ratio between 30 dB and 70 dB.

7. A method as claimed in Claim 3, characterised in that the frequency range formed by the neighbourhood of the absolute maximum (6) of the amount values of the short-term spectrum is identical to the frequency range assumed by the group (g) containing the absolute maximum of the amount values.

## Revendications

1. Procédé pour la transmission d'un signal audio, selon lequel le signal analogique est converti en un signal numérique, transmis par voie numérique et ensuite reconverti en un signal analogique, le signal étant transformé, avant la transmission, en un signal représentant le spectre instantané et des composantes de ce signal se trouvant en-dessous de seuils prédéterminés étant négligées lors du codage du signal numérique à transmettre, sur la base de lois naturelles psycho-acoustiques, la plage de fréquences entière du spectre instantané étant répartie en des groupes de fréquences (g) contenant au moins une composante spectrale et au moins un premier seuil (1) étant défini dans chaque groupe (g), qui se rapporte spécialement à la valeur absolue maximale des composantes spectrales du groupe concerné (g),
caractérisé en ce que pour les groupes de fréquences situées en-dehors des plages de fréquences discernables suivant des règles psychoacoustiques, les valeurs absolues du spectre instantané situées en-dessous de ce premier seuil (1), ne sont pas prises en considération, et que pour les groupes de fréquences situés à l'intérieur d'une plage de fréquences sélectionnée de la plage de fréquences psycho-acoustiquement discernable, il y a définition d'un deuxième seuil (2) situé endessous du premier seuil (1), en-dessous duquel les valeurs absolues du spectre instantané ne sont pas non plus prises en considération.

2. Procédé selon revendication 1, caractérisé en ce que,
une plage de fréquences psycho-acoustiquement discernable est formée de préférence en-dessous de 1kHz et/ou par l'environnement du maximum absolu (6) des valeurs absolues du spectre instantané.

3. Procédé selon revendication 1, caractérisé en ce que le segment sélectionné au sein de la plage de fréquences psycho-acoustiquement discernable est formé par la plage de fréquences située en-dessous de 1 kHz.

4. Procédé selon l'une des revendications 1 à 3, caractérisé en ce qu'un deuxième seuil (2) est agencé de préférence à 10 dB en-dessous du premier seuil (1).

5. Procédé selon revendication 1, caractérisé en ce que le premier seuil (1) est défini par le rapport logarithmique entre la valeur effective de la valeur absolue maximale des composantes spectrales de chaque groupe (g) et la racine de l'énergie moyenne de toutes les composantes spectrales de ce groupe (g), multiplié par un facteur constant, de préférence 3.

6. Procédé selon revendication 5, caractérisé en ce que le premier seuil (1) est limité à un domaine de variation du rapport logarithmique entre 30dB et 70dB.

7. Procédé selon revendication 3, caractérisé en ce que la plage de fréquences formée par l'environnement du maximum absolu (6) des valeurs absolues du spectre instantané correspond à la plage de fréquences occupée par le groupe g contenant le maximum absolu des valeurs absolues.
